# EUROPEAN PATENT APPLICATION

(11) **EP 0 997 874 A2**
(43) Date of publication of application: **03.05.2000**
(21) Application number: 99307678.5
(22) Date of filing: 29.09.1999
(51) Int. Cl.: G11B 7/004

(54) **Information storage system**

(30) Priority: 28.10.1998 US 181312
(71) Applicant: Hewlett-Packard Company, Palo Alto, California 94304 (US)
(72) Inventor: Abramovitch, Daniel Y., Palo Alto, California 94306 (US)
(74) Representative: Jehan, Robert

(57) **Abstract**

Method and apparatus for adjusting the amplitude of a clock reference signal during write pulses in optical storage systems provides, in a first embodiment, feed-forward gain adjustment, allowing the state of the write signal to select the appropriate gain level. In a second embodiment, the write pulse is used to cause the clock signal to only be sampled between write pulses.

## Description

The present invention pertains to an information storage system storage systems.

In optical storage systems, a laser is typically used to read, write, and optionally erase data stored in a rotating medium. During these processes, light reflecting from the medium is used for other processes, such as tracking the optical head with respect to the medium, adjusting the rotational velocity of the medium, and recovering clock information.

Recovered clock information is used typically in a phase locked loop (PLL) which locks to a clock reference and generates a write data clock. One issue that arises with such a PLL is the inability to distinguish at high speed the differences between amplitude and phase differences. One approach to handling amplitude differences uses techniques such as automatic gain control (AGC) circuitry to normalise signal amplitude into the PLL. However, for applications such as DVD-RW and DVD-RAM, these AGC structures are too slow. This is especially true given the extreme changes in laser power and therefore in reflected light during the rapid and dramatic changes in laser power from the level needed to read marks up to the levels needed to write and erase marks and back down again.

Another approach is a normaliser circuit which divides the various outputs of the optical detector by the sum of all the detector outputs. However, currently available normaliser designs are too slow to track the rapid changes between the read, write, and erase levels. Another alternative approach uses a hard limiter. The limiter essentially discards all amplitude information contained in the signal, retaining only the zero crossing information, which is passed to the PLL. While the limiter approach may be acceptable in a number of circumstances, such as where design simplicity is needed, it is susceptible to noise. For improved noise rejection then the limiter approach is unsatisfactory; traditional AGC circuitry and normaliser designs are too slow.

The present invention seeks to provide an improved storage system.

According to an aspect of the present invention there is provided an information storage system as specified in claim 1.

The preferred embodiment can provide a way to stabilise the signal level to the PLL, adjusting for amplitude changes due to the rapid changes in laser power levels from read to write to erase, while retaining noise immunity.

In a preferred embodiment, amplitude changes in the reference signal to the PLL in an optical storage system are compensated for by taking advantage of knowledge of the state of the write signal. In a first embodiment of the invention, the write signal is used to select the appropriate gain to provide a normalised clock level to the PLL in a feed-forward fashion. In a second embodiment of the invention, the write signal is used to sample the reference clock between write pulses.

An embodiment of the present invention is described below, by way of example only, with reference to the accompanying drawings, in which:
Fig. 1 shows a mixing PLL in an optical system,
Fig. 2 shows a diagram of a write pulse,
Fig. 3 shows a first embodiment of the present invention,
Fig. 4 shows a second embodiment of the present invention,
Fig. 5 shows a third embodiment of the present invention, and
Fig. 6 shows a fourth embodiment of the present invention.

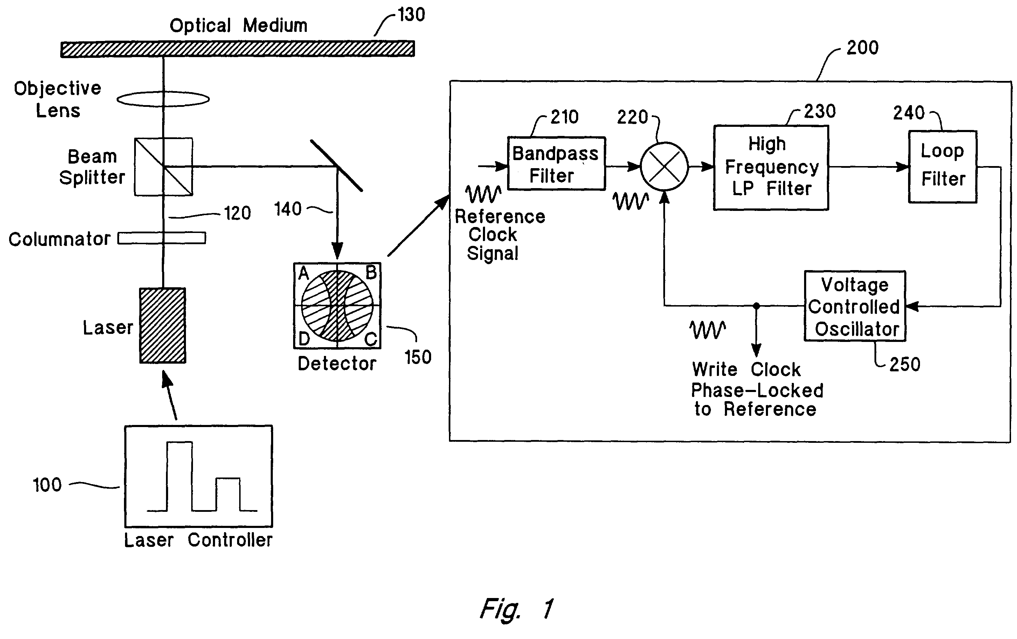

Fig. 1 shows a mixing PLL in an optical data storage system. Write controller 100 sends signals controlling the power level of laser 110. Laser Radiation 120 is directed to storage media 130, reflecting 140 to optical pickup 150. The signal from optical pickup 150 is supplied to Phase Locked Loop subsystem 200, first going through band pass filter 210. The operation of Phase Locked Loops is understood in the art and is described for example in *The Art of Electronics* by Horowitz and Hill, 2nd Edition, Cambridge University Press, 1989, section 9.27, pp. 641-655. Band pass filter 210 passes only those frequencies of interest to mixer 220 where they are combined with the output of VCO 250. This signal contains both the phase error and a high frequency component, typically at twice the VCO frequency. This signal is in turn sent through low pass filter 230 which attenuates the high frequency component, producing a phase error signal. This phase error signal is conditioned by loop filter 240 and used to control the input of voltage controlled oscillator (VCO) 250, which also feeds mixer 220. VCO 250 may also include a frequency divider on its output, not shown in this diagram. It is common to run the VCO at a frequency many times that of the reference frequency, making the loop what is known as a harmonic locking loop; in the preferred embodiment the VCO runs at 8 times the reference frequency.

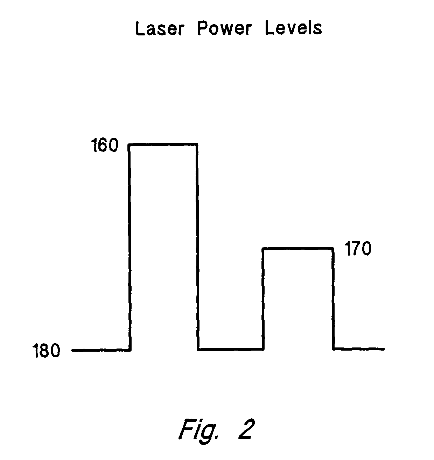

Fig. 2 shows the diagram of a write pulse, representing the different power levels generated by laser 110 of Fig. 1. The lowest power level is read level 180 used in reading information from the storage medium, followed by erase level 170, used to erase previously stored information, and the highest power, write level 160, used for writing information There is also a fourth state for the laser, off, not significant in this embodiment. In operation, these different power levels of laser 110 result in rapid and dramatic changes in the level of reflected radiation 140 impinging upon optical pickup 150. The voltage levels vary with detector configuration, but typical laser power levels for write, erase, and read are 10 milliWatts (mW), 5mW, and 1mW respectively. For a detector with linear response to incident light power the output voltage would swing over a 10 to 1 range. PLL 200 for best performance requires a fairly stable level of reference signal input to band pass filter 210. Automatic Gain Control (AGC) amplifiers and normalisers are too slow to deal with the rapid changes in power levels

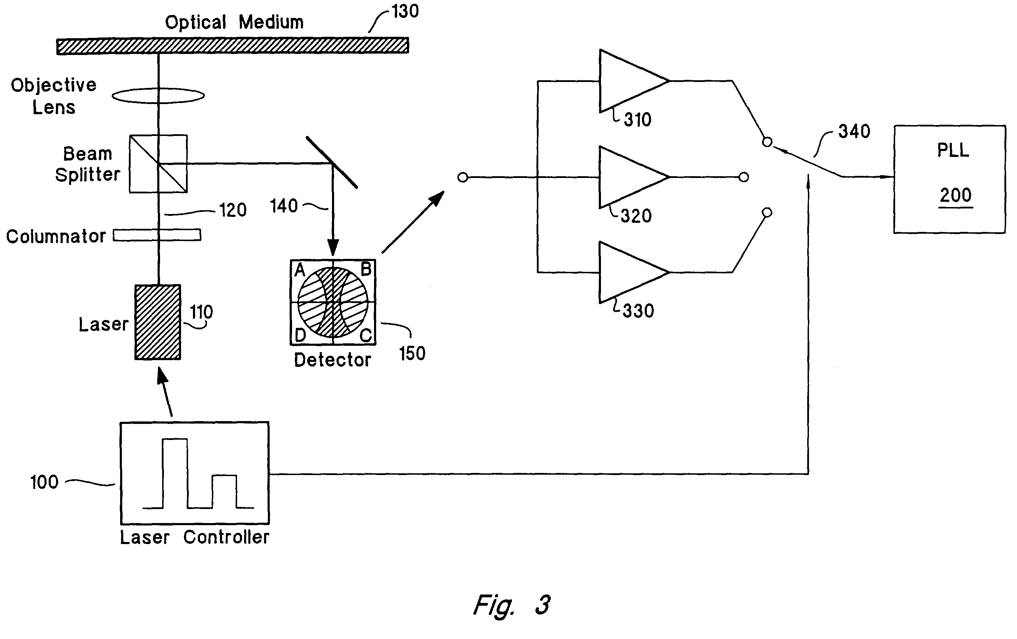

Fig. 3 shows a first embodiment of the present invention making use of information in the write signal to condition the input to the PLL. The level of the write signal is used to select the amount of gain for an amplifier stage; the least amount of gain is required for write levels, the most gain for read levels. In this embodiment write controller 100 sends write pulses to laser 110 and switch 340. Optical pickup 150 feeds amplifiers 310, 320, and 330. Each of these amplifiers has a preset gain. The level of the write pulse from write controller 100 selects the proper amplifier gain by selecting the proper amplifier output using switch 340. While this may be implemented using one amplifier with selectable gain, the preferred embodiment uses separate gain stages driven in parallel to simplify switching issues. Typical gain levels for write, erase, and read are 1 (0 dB) for write, 2 (6 dB) for erase, and 10 (20 dB) for read. An alternative topology is to use a plurality of lower gain amplifiers connected in series, selecting the output of the final amplifier for the highest gain level, the output of the preceding amplifier for the next lower gain level, and so on. This topology is more complex as it involves changing the effective group delay of the signal through the amplifier chain as the different gain levels are selected.

While this switched-gain arrangement may be inserted in the PLL between band pass filter 210 and mixer 220, this is not the preferred embodiment, as the transient response and slew rate of the filter may affect PLL behaviour due to the very high frequency nature of the pulses.

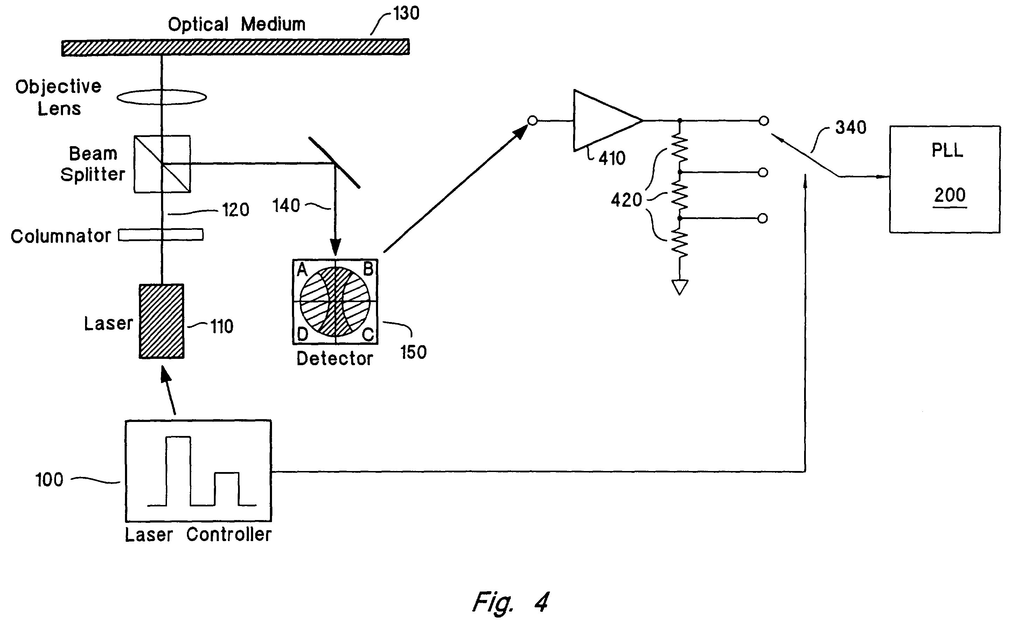

A second embodiment of the present invention is shown in Fig. 4. In this embodiment multiple gain levels are provided as in the first embodiment, but here using one gain stage 410 followed by tapped attenuator 420. When switch 340 connects directly to the output of gain stage 410 the most amplification is provided, corresponding to the high gain required for read pulses. The remaining settings of switch 340 along tapped attenuator 420 provide progressively less gain, corresponding to erase and write levels.

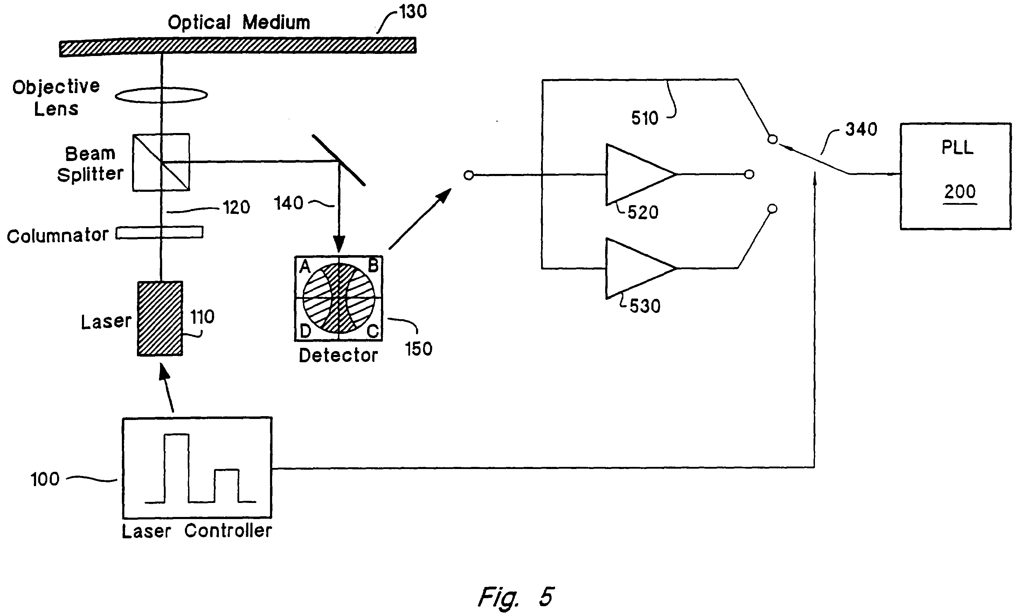

In examining the topology of Fig. 3, three gain levels are provided in normalising signal levels between optical pickup 150 and PLL 200. Optical pickup 150 and PLL 200 may be designed so the gain required for one of the signal levels is 1. A gain of 1 corresponds to a simple connection; no amplifier is needed. This topology is shown in Fig. 5. Line 510 between optical pickup 150 and switch 340 corresponds to an amplifier with a gain of 1. Amplifiers 520 and 530 provide the two other gain levels required. If a gain of 1 is selected for the read level, when the signal level from optical pickup 150 has the lowest amplitude, then the gains required for amplifiers 520 and 530 will be less than 1; they will be attenuators. This topology may be implemented as shown in Fig. 4, making amplifier 410 have a gain of 1, and replacing it with a direct connection between optical block 150 and the top of resistive divider 420.

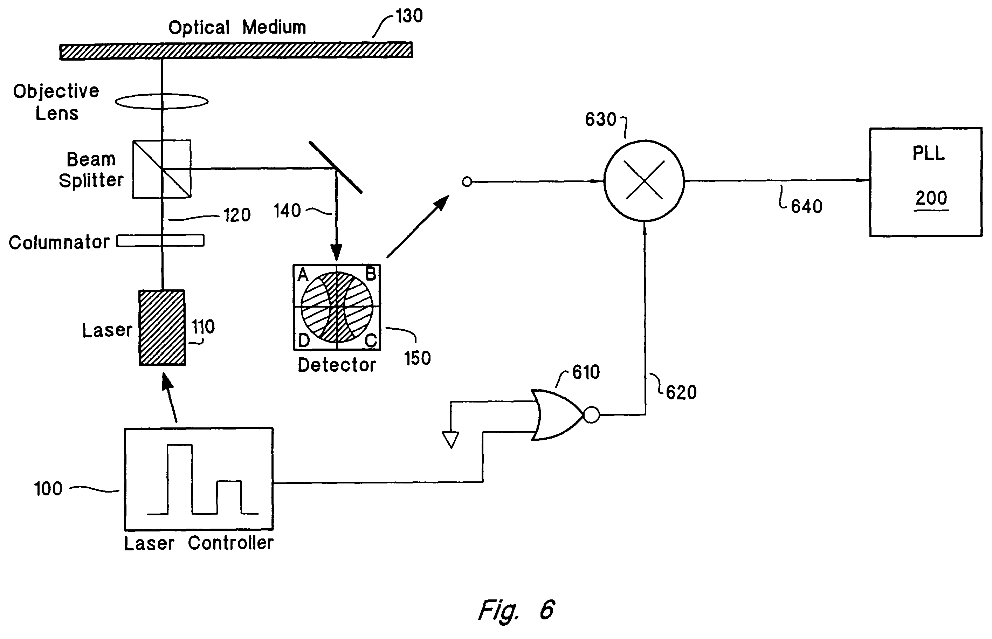

Consider again the embodiment of Fig. 3. The nature of PLL operation is such that in the absence of an error signal, PLL VCO 250 runs at a constant frequency. Assign amplifier 310 a gain of 1 for read pulses. Assign amplifiers 320 and 330 used for erase and write pulses gains of zero. Thus, the signal from optical pickup 150 will be passed through switch 340 to PLL 200 only during read pulses. Since amplifier 310 has a gain of 1 it may be replaced by a direct connection. Since amplifiers 320 and 330 have gains of zero they may be eliminated. A fourth embodiment of the present invention results as shown in Fig. 6. This embodiment uses the write signals from write controller 100 to gate the signal input to PLL 200 so that the signal is only applied to the PLL during read operations. In this embodiment, write controller 100 produces pulses sent to both laser 110 and gate 610. As shown, gate 610 is used as an inverter, so that its output 620 is a logical "1" only when write controller 100 is producing pulses at the read level. The signal from optical pickup 150 is combined with this switching signal by mixer/switch 630, sending reference signal 640 to PLL 200 only when laser 110 is in read mode. By gating the reference signal off during write and erase pulses, the amplitude shifts in the reference signal to PLL 200 during these states are avoided. During erase and write pulses, with no input to PLL 200, there is no phase error for PLL 200 to follow, and the loop is opened with PLL VCO 250 maintaining its current phase and frequency. This switch may be preceded by a gain stage; it is not required to have a gain of 1 for this embodiment.

While this gating is shown preferentially between optical pickup 150 and PLL 200, it may also be accomplished within the PLL circuitry, for example by gating the signal between band pass filter 210 and mixer 220. Gating may also be accomplished in mixer/phase detector 220, noting again that such topologies may suffer somewhat in performance due to slew rate limiting and transient response of filter 210.

The foregoing detailed description of the present invention is provided for the purpose of illustration and is not intended to be exhaustive or to limit the invention to the precise embodiments disclosed.

The disclosures in United States patent application no. 09/181,312, from which this application claims priority, and in the abstract accompanying this application are incorporated herein by reference.

## Claims

1. An information storage system including a laser having a plurality of power levels, an optical pickup including an output signal designed to vary in strength corresponding to the plurality of laser power levels, a phase locked loop (PLL), and amplifier means connected between the optical pickup and the PLL having a plurality of gain levels, each gain level being selected according to the power level of the laser.

2. A system as in claim 1, wherein the amplifier means includes a plurality of individual amplifiers each connected to the optical pickup, each amplifier with a preset gain and a switch operable according to the laser power level to select the output of the amplifier having the proper gain for that laser power level.

3. A system as in claim 1, wherein the amplifier means includes a single amplifier followed by an attenuator network having a plurality of attenuation steps and a switch operable according to the laser power level to select the attenuation step having the proper gain for that laser power level.

4. A system as in claim 1, wherein the amplifier means includes a plurality of gain stages connected in series and a switch connected to the output of each of the gain stages, the switch operable according to the laser power level to select the proper gain for that laser power level.

5. A system as in claim 1, wherein the plurality of laser power levels correspond to levels for reading, writing, and erasing information, and the plurality of gain levels for the amplifier correspond to gain levels for reading, writing, and erasing information.

6. A system as in claim 5, wherein the gain levels for reading, writing, and erasing information are all non-zero.

7. A system as in claim 5, wherein the gain level for one or more of the levels of reading, writing, and erasing information is non-zero and the remaining gain levels are zero.

8. A system as in claim 7, wherein the non-zero gain level corresponds to the read level.
